# EUROPEAN PATENT APPLICATION

(11) **EP 4 571 817 A1**
(43) Date of publication of application: **18.06.2025**
(21) Application number: 23216807.0
(22) Date of filing: 14.12.2023
(51) Int. Cl.: H01L 21/28, H01L 29/51, H01L 29/66, H10B 51/30, H10B 53/30

(54) **HAFNIUM ZIRCONIUM OXIDE FERROELECTRIC DEVICE**

(71) Applicant: Imec VZW, 3001 Leuven (BE)
(72) Inventor: POPOVICI, Mihaela Ioana, 3053 Haasrode (BE)
(74) Representative: Winger

(57) **Abstract**

An intermediate (1, 11) in the formation of a ferroelectric device (10, 110), comprising: a hafnium zirconium oxide layer (4) comprising a tetragonal phase, and at least one metal oxide layer (5, 51, 52) in physical contact with the hafnium zirconium oxide layer (4), wherein the metal oxide layer (5, 51, 52) comprises at least one metal cation selected from the list consisting of Cr having an oxidation state of 5 or 6, W having an oxidation state of 5 or 6, Mo having an oxidation state of 5 or 6, Ce having an oxidation state of 4, and V having an oxidation state of 4 or 5, wherein if Cr is present, then W and/or Mo and/or V is also present.

## Description

### Technical field of the invention

The present invention relates to the field of ferroelectric devices. In particular, the present invention relates to ferroelectric devices (and intermediates thereto) comprising hafnium zirconium oxide.

### Background of the invention

The field of non-volatile memory technology is a critical area of research and development in the electronics industry, as it plays a vital role in a wide range of applications, from mobile devices to large-scale data centers. Among the various types of non-volatile memory, ferroelectric random-access memory (FeRAM or FRAM) has garnered significant attention due to its potential for highspeed operation, low power consumption, and ability to retain data without a continuous power supply. Similar advantages have been noted for ferroelectric field-effect transistor memory, which makes use of ferroelectric field-effect transistors to provide a type of single transistor non-volatile memory.

Ferroelectric materials are characterized by their ability to exhibit spontaneous electric polarization, which can be reversed by the application of an external electric field. This property is harnessed in FeRAM devices, where the direction of polarization corresponds to the binary data states '0' and '1'. The ability to switch polarization states rapidly and with minimal energy input is crucial for the performance of FeRAM.

A significant challenge in the field is the scaling down of ferroelectric films to ultra-thin layers, particularly those with thicknesses below 10 nanometers. As devices become smaller and more compact, the demand for thin ferroelectric films that maintain high polarization and endurance is increasing. Achieving a remanent polarization (2Pr) value above 30 micro-Coulombs per square centimeter (µC/cm²) and an endurance of at least 1E+11, i.e., 10¹¹, cycles are key targets that researchers and engineers are striving to meet.

The development of ferroelectric hafnia (HfO₂) and hafnium zirconate (HfZrO₂) has been a focus of recent efforts to improve the ferroelectric properties of thin films. These materials are promising due to their compatibility with current semiconductor manufacturing processes and their potential to be integrated into silicon-based electronics. However, the challenge remains to enhance their ferroelectric properties to meet the stringent requirements of modern memory devices.

Despite the progress made in the field, there is still a need for further advancements to address the challenges associated with the scaling of ferroelectric materials. The quest for materials and structures that can deliver the desired performance at reduced dimensions continues to drive innovation in ferroelectric memory technology.

There is thus still a need in the art for devices and methods that address at least some of the above problems.

### Summary of the invention

It is an object of the present invention to provide a good intermediate in the formation of a ferroelectric device. It is a further object of the present invention to provide a good method for forming a ferroelectric device. It is still a further object of the present invention to provide a good ferroelectric device. It is yet a further object of the present invention to provide a good non-volatile memory device.

The above objectives are accomplished by a method and devices according to the present invention.

In a first aspect, the present invention relates to an intermediate in the formation of a ferroelectric device, comprising:
a hafnium zirconium oxide layer comprising a tetragonal phase, and
at least one metal oxide layer in physical contact with the hafnium zirconium oxide layer, wherein the metal oxide layer comprises at least one metal cation selected from the list consisting of Cr having an oxidation state of 5 or 6, W having an oxidation state of 5 or 6, Mo having an oxidation state of 5 or 6, Ce having an oxidation state of 4, and V having an oxidation state of 4 or 5, wherein if Cr is present, then W and/or Mo and/or V is also present.

In the second aspect, the present invention relates to a method for forming a ferroelectric device, the method comprising the steps of:
i) providing the intermediate in accordance with embodiments of the first aspect of the present invention, then
ii) inducing a reduction of one or more of the at least one metal cation of the metal oxide layer so as to transfer oxygen atoms from the metal oxide layer into the hafnium zirconium oxide layer thereby converting at least part of said tetragonal phase into an orthorhombic phase.

In a third aspect, the present invention relates to a ferroelectric device obtainable by the method in accordance with embodiments of the second aspect of the present invention.

In a fourth aspect, the present invention relates to a non-volatile memory device comprising a memory cell array, wherein at least one memory cell in the memory cell array comprises a ferroelectric device in accordance with embodiments of the third aspect of the present invention.

It is an advantage of embodiments of the present invention that the tetragonal phase of the hafnium zirconium oxide layer may be straightforwardly converted to the orthorhombic phase. It is an advantage of embodiments of the present invention that, thereby, the ferroelectric properties of the hafnium zirconium oxide layer may be straightforwardly improved. It is an advantage of embodiments of the present invention that a ferroelectric device having a good remanent polarization and endurance may be achieved, even when the hafnium zirconium oxide layer is thin. It is yet another advantage of embodiments of the present invention that the gradual phase transition ensures high endurance, making the device suitable for applications requiring a large number of operational cycles.

It is an advantage of embodiments of the present invention that the metal oxide layer can be composed of various metal cations that may be reduced to lower oxidation states without compromising the conductivity preferred for the ferroelectric device's functionality. It is a further advantage of embodiments of the present invention that the method for forming the ferroelectric device may facilitate the desired phase transition in the hafnium zirconium oxide layer from the tetragonal phase to the orthorhombic phase.

It is an advantage of embodiments of the present invention that, the at least one metal oxide layer being present in the ferroelectric device, the ferroelectric properties of the hafnium zirconium oxide layer may be restored when they are weakened during the lifetime of the ferroelectric device.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 is a schematic representation of a vertical cross-section of an intermediate in the formation of a ferroelectric device that is a ferroelectric capacitor, in accordance with embodiments of the present invention.
FIG. 2 is a schematic representation of a vertical cross-section of the ferroelectric capacitor in accordance with embodiments of the present invention.
FIG. 3 is a schematic representation of a vertical cross-section of an intermediate in the formation of a ferroelectric device that is a ferroelectric field-effect transistor, in accordance with embodiments of the present invention.
FIG. 4 is a schematic representation of a vertical cross-section of the ferroelectric field-effect transistor in accordance with embodiments of the present invention.
FIG. 5 is a schematic representation of a perspective view of a non-volatile memory device comprising a memory cell array in accordance with embodiments of the present invention.
FIG. 6 is a plot of the polarization as a function of applied electric field, applied to a reference ferroelectric device, and to a ferroelectric device in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It should be noted that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it should be noted that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect, the present invention relates to an intermediate in the formation of a ferroelectric device, comprising:
a hafnium zirconium oxide layer comprising a tetragonal phase, and
at least one metal oxide layer in physical contact with the hafnium zirconium oxide layer, wherein the metal oxide layer comprises at least one metal cation selected from the list consisting of Cr having an oxidation state of 5 or 6, W having an oxidation state of 5 or 6, Mo having an oxidation state of 5 or 6, Ce having an oxidation state of 4, and V having an oxidation state of 4 or 5, wherein if Cr is present, then W and/or Mo and/or V is also present.

In embodiments, the at least one metal oxide layer may comprise at least one metal cation selected from the list consisting of Cr having an oxidation state of 6, W having an oxidation state of 6, Mo having an oxidation state of 6, Ce having an oxidation state of 4, and V having an oxidation state of 5. In embodiments, the at least one metal oxide layer may comprise at least one metal oxide selected from the list consisting of CrOs, WO₃, MoOs, CeO₂ and V₂O₃. These embodiments provide a specific selection of metal cations with high oxidation states that are beneficial for the reduction process to improve ferroelectric properties. It is an advantage of these embodiments that these metal cations, being in a high oxidation state, may be straightforwardly reduced for releasing oxygen atoms, from the metal oxide layer, to be transferred into the hafnium zirconium oxide layer.

In embodiments, the metal oxide layer may be WO₃. WO₃ has good compatibility with the hafnium zirconium oxide layer. Furthermore, WO₃ has a good stability and may be safely handled, is widely available, and has an oxidation state that may be easily controlled or tuned.

In embodiments, the metal oxide layer has a thickness of from 0.5 to 5.0 nm, preferably from 1.0 to 2.0 nanometres. In these embodiments, the thickness may be small enough so that the effect of the metal oxide layer on the electrical properties of the ferroelectric device may be limited. In embodiments, the thickness may be large enough so that the stability of the layer, also during and after reducing the metal cation, may be good.

In embodiments, the hafnium zirconium oxide layer and the at least one metal oxide layer may be provided over a bottom electrode layer and below a top electrode layer. These embodiments provide an intermediate in the formation of a ferroelectric capacitor, which may, for example, be used in ferroelectric random-access memory.

In embodiments, the hafnium zirconium oxide layer and the at least one metal oxide layer may be provided over a semiconductor channel and below a top electrode layer. These embodiments provide an intermediate in the formation of a ferroelectric field-effect transistor, which may, for example, be used in ferroelectric random-access memory.

In embodiments, the at least one metal oxide layer consists of one or two metal oxide layers. The hafnium zirconium oxide layer may be provided above a first of the at least one metal oxide layer. A first of the at least one metal oxide layer may be provided above the hafnium zirconium oxide layer. The hafnium zirconium oxide layer may be provided above a first of the at least one metal oxide layer, and a second of the at least one metal oxide layer may be provided above the hafnium zirconium oxide layer. In other words, the hafnium zirconium oxide layer may be sandwiched between two metal oxide layers of the at least one metal oxide layer.

Any features of any embodiment of the first aspect may be independently as correspondingly described for any embodiment of any of the other aspects of the present invention.

In the second aspect, the present invention relates to a method for forming a ferroelectric device, the method comprising the steps of:
i) providing the intermediate in accordance with embodiments of the first aspect of the present invention, then
ii) inducing a reduction of one or more of the at least one metal cation of the metal oxide layer so as to transfer oxygen atoms from the metal oxide layer into the hafnium zirconium oxide layer thereby converting at least part of said tetragonal phase into an orthorhombic phase.

Without being bound by theory, the (non-ferro-electric) tetragonal phase comprises a higher concentration of oxygen vacancies than the (ferro-electric) orthorhombic phase. By filling part of the vacancies of the tetragonal phase with said oxygen atoms, the tetragonal phase may be converted into the orthorhombic phase.

In some embodiments, the hafnium zirconium oxide layer of the intermediate may comprise an orthorhombic phase, having a non-zero ferroelectricity. The intermediate may, thus, function as a ferroelectric device itself. In these embodiments, the method may modify or improve the ferroelectric properties of the intermediate so as to achieve the ferroelectric device in accordance with embodiments of the present invention.

In step ii, the oxidation state of the metal cation may be reduced to an oxidation state of at most 4 when the metal cation is Cr, W, V and Mo, or to an oxidation state of at most 3 when the metal cation is Ce. In step ii, the oxidation state of Cr, before the reduction being 5 or 6, may be reduced to an oxidation state of 3 or 4. In step ii, the oxidation state of W, before the reduction being 5 or 6, may be reduced to an oxidation state of 3 or 4. In step ii, the oxidation state of Mo, before the reduction being 5 or 6, may be reduced to an oxidation state of 3 or 4. In step ii, the oxidation state of Ce, before the reduction being 4, may be reduced to an oxidation state of 3. In step ii, the oxidation state of V, before the reduction being 5, may be reduced to an oxidation state of 4.

The oxygen atoms from the metal oxide layer that are transferred into the hafnium zirconium oxide layer, may distort the crystal lattice of the tetragonal phase. This distortion may result in a conversion of the tetragonal phase into the orthorhombic phase. Without being bound by theory, the oxygen atoms may fill oxygen vacancies in the crystal lattice of the tetragonal phase, which may result in elongation of bonds within the crystal lattice of the tetragonal phase so that the tetragonal phase may convert into the orthorhombic phase.

In embodiments, the hafnium zirconium oxide layer may be undoped. In embodiments, the hafnium zirconium oxide layer may be doped with a lanthanide. Said lanthanide may provide oxygen vacancies, which may enable the hafnium zirconium oxide layer to be crystallized as the orthorhombic phase.

In embodiments, the hafnium zirconium oxide layer may be doped with a redox-active dopant, wherein the dopant and at least one of the at least one metal cation form a redox pair. It is an advantage of these embodiments that a good control of the oxygen vacancies in the hafnium zirconium oxide layer may be achieved. After the device is formed and the hafnium zirconium oxide layer comprises the orthorhombic phase, when a voltage is applied to the metal oxide layer, e.g., during voltage cycling of the device (which is inherent in functioning of the device), further metal cations in the metal oxide layer may be reduced so that more oxygen atoms may be released into the hafnium zirconium oxide layer. These oxygen atoms could fill the oxygen vacancies of the hafnium zirconium oxide layer, resulting in a conversion of the (ferro-electric) orthorhombic phase into the (non-ferro-electric) monoclinic phase (which is reached when the concentration of oxygen vacancies is very low). When the redox-active dopant is present, the oxygen atoms may react with the redox-active dopant, instead of filling the oxygen vacancies. Thus, advantageously, as a consequence of the oxidation of the redox-active dopant, by accepting the excess of oxygen and increasing its oxidation state, in the hafnium zirconium oxide layer, an unwanted transition of orthorhombic to monoclinic phase, which may appear when the oxygen vacancies are completely supressed, may be inhibited. Therefore, the endurance or lifetime of the device may be increased.

The redox-active dopant may impede a transition from the orthorhombic phase to the monoclinic phase, but a transition from the tetragonal phase to the orthorhombic phase may occur due to very low activation energy of tetragonal to orthorhombic phase transition. Indeed, the concentration of oxygen vacancies in the tetragonal phase may be high so that a reaction rate between the oxygen atoms and the oxygen vacancies may be sufficiently high to occur for the tetragonal phase, even in presence of the redox active dopant.

In embodiments, said redox-active dopant may be at least one of niobium, chromium, tungsten, vanadium, and molybdenum, having an oxidation state of at most 4, and cerium having an oxidation state of at most 3. These elements may be easily oxidized by the oxygen atoms transferred into the hafnium zirconium oxide layer. In embodiments, a concentration of the redox-active dopant in the hafnium zirconium oxide layer may be from 0.5 to 4.5 at.-%, preferably from 1.5 to 3.5 at.-%.

In embodiments, the hafnium zirconium oxide layer doped with a dopant may be provided by atomic layer deposition, chemical vapor deposition or physical vapor deposition. By said deposition, the hafnium zirconium oxide layer, comprising hafnium zirconium oxide crystals or crystallites in the tetragonal phase, may be formed. In embodiments, the hafnium zirconium oxide layer doped with a dopant - e.g., the redox-active dopant or the lanthanide dopant - may be provided by depositing, alternatingly: a sublayer of hafnium zirconium oxide, and a sublayer of an oxide of the dopant. The sublayers may be deposited by atomic layer deposition, chemical vapor deposition or physical vapor deposition .

In embodiments, an interfacial layer comprising TiO₂, MoOₓ, HfO₂, ZrO₂, or WO₃, wherein x is from 2 to 3, may be present between the bottom electrode layer and the hafnium zirconium oxide layer or between the top electrode layer and the hafnium zirconium oxide layer, wherein the interfacial layer is in physical contact with the hafnium zirconium oxide layer on the side where the metal oxide layer is not present. Preferably, the intermediate comprises the hafnium zirconium oxide layer over, e.g., in physical contact with, the interfacial layer. In embodiments, in step i, providing the intermediate may comprise providing the hafnium zirconium oxide layer over, e.g., in physical contact with, the interfacial layer. The interfacial layer may provide the hafnium zirconium oxide layer with larger grains and a favorable grain orientation. Furthermore, the interfacial layer may induce large tensile stress into the hafnium zirconium oxide layer, which may result in a large remanent polarization. In embodiments comprising the interfacial layer, the at least one metal oxide layer typically consists of a single metal oxide layer.

In embodiments, step ii comprises applying a voltage to the intermediate in accordance with embodiments of the first aspect of the present invention. Application of the voltage to induce the reduction process is a straightforward and controllable technique for modifying the material properties. In embodiments, applying the voltage comprises cycling the voltage. Said cycling may be inherent in the use of the ferroelectric device. For example, said cycling may be provided by switching the ferroelectric device between different ferroelectric states. The top or bottom electrode layer may electrically contact the metal oxide layer. The voltage may be applied to the metal oxide layer via said top or bottom electrode layer.

In embodiments, step ii comprises applying a thermal treatment to the intermediate of any embodiments of the first aspect of the present invention. In embodiments, applying the thermal treatment may comprise heating the intermediate in accordance with embodiments of the present invention to a temperature of from 100°C to 600°C, preferably from 300°C to 400°C. Said thermal treatment may be provided by a crystallization anneal, which may be inherently used for forming the orthorhombic phase of the hafnium zirconium oxide layer. Directly after deposition, the hafnium zirconium oxide layer may comprise tetragonal hafnium zirconium oxide crystallites and, possibly, amorphous hafnium zirconium oxide. In embodiments of the present invention, the crystallization anneal may convert the tetragonal crystallites into an orthorhombic crystalline phase. The crystallization anneal may convert the amorphous oxide, typically via the crystalline tetragonal phase, into the crystalline orthorhombic phase.

In preferred embodiments, the metal oxide layer provided in step i is provided by atomic layer deposition. These embodiments may provide good control of the features of the metal oxide layer. In embodiments, the metal oxide layer provided in step i may be provided by depositing the metal by physical vapor deposition, then applying an oxidizing plasma so as to oxidize the deposited metal. Said oxidation may, for example, be performed by application of an oxygen plasma or an ozone treatment.

Any features of any embodiment of the second aspect may be independently as correspondingly described for any embodiment of any of the other aspects of the present invention.

In a third aspect, the present invention relates to a ferroelectric device obtainable by the method in accordance with embodiments of the second aspect of the present invention.

In embodiments, the ferroelectric device may comprise a hafnium zirconium oxide layer comprising an orthorhombic phase, and at least one metal oxide layer in physical contact with the hafnium zirconium oxide layer, wherein the metal oxide layer comprises at least one metal cation selected from the list consisting of Cr, W, V, and Mo, having an oxidation state of at most 4 or Ce having an oxidation state of at most 3.

In embodiments, the hafnium zirconium oxide layer and the at least one metal oxide layer may be provided over a bottom electrode layer and/or below a top electrode layer. In embodiments, the bottom and/or top electrode layer may comprise titanium nitride, chromium, chromium-tungsten or ruthenium-tungsten. Preferably, the at least one metal oxide layer is in electrical contact with one of the bottom electrode layer and the top electrode layer.

In embodiments, the hafnium zirconium oxide layer and the at least one metal oxide layer are located over a bottom electrode layer and below a top electrode layer.

In embodiments, the ferroelectric device is a ferroelectric capacitor, and the hafnium zirconium oxide layer and the at least one metal oxide layer are provided over a bottom electrode layer and below a top electrode layer.

In embodiments, the ferroelectric device is a ferroelectric field-effect transistor, and the hafnium zirconium oxide layer and the at least one metal oxide layer are provided over a semiconductor channel and below a top electrode layer. In embodiments, the semiconductor channel may be an oxide semiconductor channel. The semiconductor channel may function as bottom contact when switching the ferroelectric layer.

Any features of any embodiment of the third aspect may be independently as correspondingly described for any embodiment of any of the other aspects of the present invention.

In a fourth aspect, the present invention relates to a non-volatile memory device comprising a memory cell array, wherein at least one memory cell in the memory cell array comprises a ferroelectric device in accordance with embodiments of the third aspect of the present invention or an intermediate in accordance with embodiments of the first aspect. In embodiments, the ferroelectric device may be a ferroelectric capacitor, which may function as a ferroelectric random-access memory cell. In embodiments, the ferroelectric device may be a ferroelectric field-effect transistor, which may function as a ferroelectric field-effect transistor memory cell.

Any features of any embodiment of the fourth aspect may be independently as correspondingly described for any embodiment of any of the other aspects of the present invention.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

### Example 1: Forming a ferroelectric capacitor

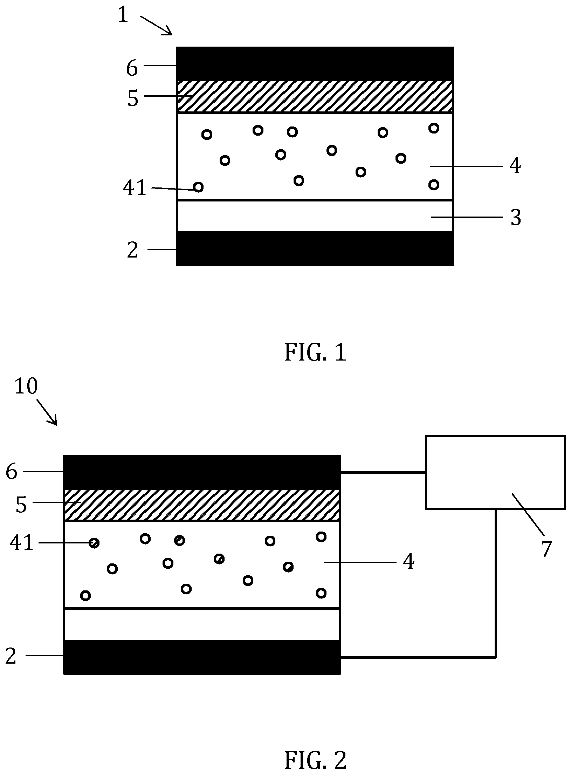

Reference is made to FIG. 1, which is a schematic representation of a vertical cross-section of an intermediate 1 in the formation of a ferroelectric device that is a ferroelectric capacitor, in accordance with embodiments of the present invention.

In the present example, the intermediate 1 in the formation of a ferroelectric device comprises a bottom electrode layer 2. The intermediate 1 in the formation of a ferroelectric device comprises an interfacial layer 3 over, e.g., in physical contact with, the bottom electrode layer 2. The intermediate 1 in the formation of a ferroelectric device comprises a hafnium zirconium oxide layer 4 over, e.g., on, the interfacial layer 3.

In the present example, without being bound by theory, the hafnium zirconium oxide layer 4 may comprise a high concentration of oxygen vacancies 41. In this example, the hafnium zirconium oxide layer 4 comprises predominantly a tetragonal phase. The hafnium zirconium oxide layer 4 of the intermediate 1 in the formation of a ferroelectric device may further comprise an orthorhombic phase and/or a monoclinic phase. The hafnium zirconium oxide layer 4 may further comprise amorphous hafnium zirconium oxide.

The intermediate 1 in the formation of a ferroelectric device comprises a metal oxide layer 5 in physical contact with the hafnium zirconium oxide layer 4. In the present example, the metal oxide layer 5 is located in physical contact with the hafnium zirconium oxide layer 4. The metal oxide layer comprises at least one metal cation selected from the list consisting of Cr having an oxidation state of 5 or 6, W having an oxidation state of 5 or 6, Mo having an oxidation state of 5 or 6, Ce having an oxidation state of 4, and V having an oxidation state of 4 or 5, wherein if Cr is present, then W and/or Mo and/or V is also present. Each of these metal cations may be reduced towards a lower oxidation state, resulting in the release of oxygen atoms into the hafnium zirconium oxide layer 4.

In an example embodiment, the direct physical contact between the metal oxide layer 5 and the hafnium zirconium oxide layer 4, enables the injection of oxygen from the metal oxide layer 5 into the hafnium zirconium oxide layer 4. Concurrently, electrons flow from the hafnium zirconium oxide layer to the metal oxide layer. This electron movement may reduce the oxidation state of the metal cations in the metal oxide layer from a higher to a lower state. This reaction may occur due to the fact that the metal oxide layer 5 has a lower electron affinity energy than the hafnium zirconium oxide layer 4. This reaction may be very slow, and its rate may be enhanced, according to an embodiment, by a thermal treatment, e.g., a crystallization anneal, applied to the intermediate 1 in the formation of the ferroelectric device. Said crystallization anneal may further convert amorphous and/or crystallite hafnium zirconium oxide into crystalline hafnium zirconium oxide.

The rate of the reaction may be enhanced, according to another embodiment, by applying a voltage. Said voltage may be applied to the ferroelectric device when in operation, that is, during cycling of the ferroelectric device (see below).

In the present example, the metal oxide layer 5 has a thickness of from 0.5 to 5.0 nm. Said thickness is determined in a direction normal to a top surface of the metal oxide layer 5.

In the present example, the intermediate 1 in the formation of a ferroelectric device comprises a top electrode layer 6 over, e.g., on, the metal oxide layer 5.

Reference is made to FIG. 2. The oxygen atoms, which may be released by the thermal treatment from the metal oxide layer 5 into the hafnium zirconium oxide layer 4, may fill some of the oxygen vacancies 41 of the hafnium zirconium oxide layer 4. Thereby, at least part of said tetragonal phase of the hafnium zirconium oxide layer 4 is converted into an orthorhombic phase. Thereby, as the orthorhombic phase is a ferroelectric phase, the ferroelectric properties of the hafnium zirconium oxide layer 4 may be improved. Thereby, the ferroelectric device 10 is formed. In this example, the ferroelectric device 10 is a ferroelectric capacitor 10, with the ferroelectric layer that is the hafnium zirconium oxide layer 4 located between the bottom electrode layer 2 and the top electrode layer 6 that correspond to the "plates" of the ferroelectric capacitor 10.

In this example, the bottom electrode layer 2 and the top electrode layer 6 are electrically connected to a controller 7. In an embodiment, when the ferroelectric device 10 is in operation, the controller 7 is configured to apply a voltage to the top electrode layer 6 and the bottom electrode layer 2. During the cycling of the ferroelectric device 10, by applying alternative (positive and negative) cycles of voltage, a reduction of one or more of the at least one metal cations of the metal oxide layer 5 may occur so as to transfer oxygen atoms from the metal oxide layer 5 into the hafnium zirconium oxide layer 4.

In some embodiments, the hafnium zirconium oxide layer 4 may comprise redox active ions that form a redox pair with the metal cation of the metal oxide layer 5. In these embodiments, the oxygen atoms transferred into the hafnium zirconium oxide layer 4 may bind to the redox active ions (e.g., instead of filling oxygen vacancies 41). A complete suppression of oxygen vacancies 41 can, then, be avoided by oxidation of redox active ions in the hafnium oxide layer 4, said redox active ions having initially a lower oxidation state. As a consequence, an unwanted transition of orthorhombic phase into monoclinic phase may be avoided.

### Example 2: Forming a ferroelectric field-effect transistor

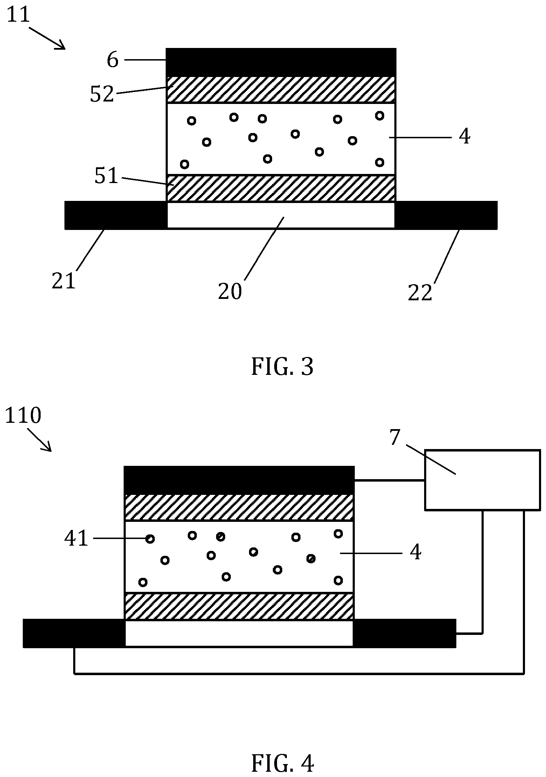

Reference is made to FIG. 3, which is a schematic representation of a vertical cross-section of an intermediate 11 in the formation of a ferroelectric device that is a ferroelectric field-effect transistor, in accordance with embodiments of the present invention.

In the present example, the intermediate 11 in the formation of a ferroelectric device comprises a semiconductor channel 20, e.g., an oxide semiconductor channel. The semiconductor channel 20 separates, e.g., laterally separates, a source 21 from a drain 22.

In the present example, the intermediate 11 in the formation of a ferroelectric device comprises a first metal oxide layer 51 over, e.g., in physical contact with, the semiconductor channel 20. The intermediate 11 in the formation of a ferroelectric device comprises a hafnium zirconium oxide layer 4 on, i.e., in physical contact with, the first metal oxide layer 51. The hafnium zirconium oxide layer 4 comprises a tetragonal phase.

In the present example, the intermediate 11 in the formation of a ferroelectric device comprises a second metal oxide layer 52, which is on, i.e., in physical contact with, the hafnium zirconium oxide layer 4. The first metal oxide layer 51 may comprise the same at least one metal cation as the second metal oxide layer 52. For example, the first metal oxide layer 51 and the second metal oxide layer 52 may both be formed of WO₃. However, that is not essential. For example, the at least one metal cation of the first metal oxide layer 51 may be different than the at least one metal cation of the second metal oxide layer 52.

In the present invention, the intermediate 11 in the formation of a ferroelectric device comprises a top electrode layer 6 over, e.g., in physical contact with, the second metal oxide layer 52. The top electrode layer 6 may function as a gate electrode of the ferroelectric field-effect transistor.

A heat treatment, e.g., by a crystallization anneal, may be applied to the intermediate 10. This may result in a reduction of the metal cation of the first metal oxide layer 51 and the second metal oxide layer 52, and the transfer of oxygen atoms from the first metal oxide layer 51 and the second metal oxide layer 52 into the hafnium zirconium oxide layer 4.

Reference is made to FIG. 4. The oxygen atoms transferred into the hafnium zirconium oxide layer 4 may induce a conversion of at least part of the tetragonal phase into an orthorhombic phase. Without being bound by theory, the oxygen atoms may fill oxygen vacancies 41 in the hafnium zirconium oxide layer 4, thereby modifying the distances and angles between oxygen and hafnium or zirconium bonds of the hafnium zirconium oxide layer 4 so that the tetragonal phase is converted into the orthorhombic phase. Thereby, the ferroelectric field-effect transistor 110 in accordance with embodiments of the present invention may be formed.

In the present example, a controller 7 is electrically coupled to the source 21, the drain 22 and the top electrode layer 6. The controller 7 is configured for applying a voltage. Said voltage may be used for operating the ferroelectric field effect transistor 110, which may inherently result in voltage cycling.

### Example 3: Non-volatile memory device

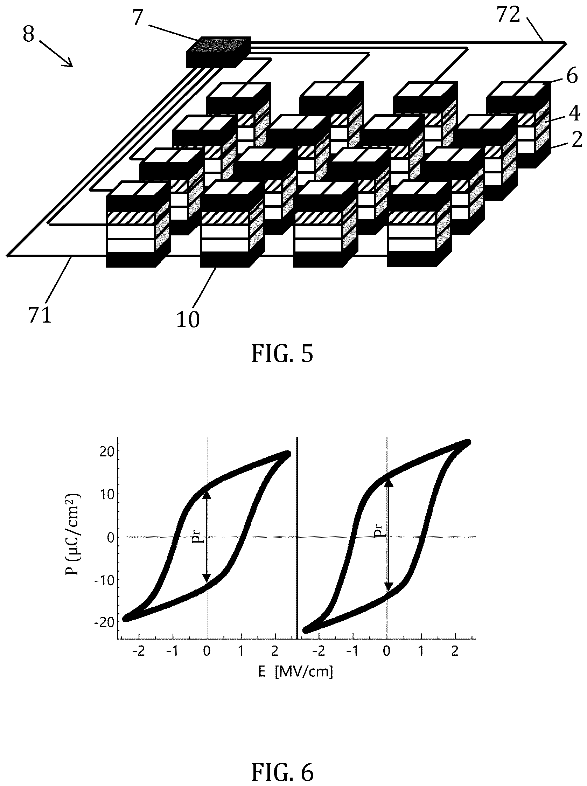

Reference is made to FIG. 5, which is a non-volatile memory device 8 comprising a memory cell array in accordance with embodiments of the present invention.

In this example, each memory cell in the memory cell array comprises a ferroelectric device 10 that is a ferroelectric capacitor 10 in accordance with embodiments of the present invention. Each ferroelectric capacitor 10 may function as a ferroelectric random access memory cell. Each ferroelectric capacitor 10 of the present example may have features that are the same as the ferroelectric capacitor of Example 1 as detailed above.

The non-volatile memory device 8 further comprises a controller 7, which may be a processor. The controller 7 may be electrically coupled to row lines 71 for addressing rows of ferroelectric capacitors 10. Herein, each row line 71 may be connected to the bottom electrode layer 2 of each ferroelectric capacitor 10 in a row of the memory cell array. The controller 7 may be electrically coupled to column lines 72 for addressing columns of ferroelectric capacitors 10. Herein, each column line 72 may be connected to the top electrode layer 6 of each ferroelectric capacitor 10 in a column of the memory cell array. Similarly as in memory cells of the state of the art, each ferroelectric capacitor 10 may be individually read or written by providing a voltage to the row line 71 and to the column line 72 electrically connected to the ferroelectric capacitor 10.

Although in the illustrated example, the non-volatile memory device 8 further comprises memory cells that are ferroelectric capacitors 10, instead, the memory cells may comprise ferroelectric field-effect transistors.

The ferroelectric hafnium zirconium oxide layer 4 in accordance with embodiments of the present invention may have a high polarization of remanent polarization and a high endurance. Therefore, the ferroelectric devices in accordance with embodiments of the present invention may provide the non-volatile memory device 8 with improved properties for retaining binary data written to the memory cells, i.e., to the ferroelectric capacitors 10, of the of the memory cell array.

### Example 4: Experiment

The ferroelectric properties were tested on a ferroelectric device in accordance with embodiments of the present invention. The ferroelectric device that was tested comprised a 10 nm thick bottom electrode layer formed of TiN at 340°C by atomic layer deposition. An interfacial layer having a thickness of 2 nm was deposited by atomic layer deposition on the bottom electrode layer. A hafnium zirconium oxide layer, doped with lanthanum, having a thickness of 8 nm was deposited by atomic layer deposition on the interfacial layer. A metal oxide layer having a thickness of 2 nm was deposited by atomic layer deposition on the hafnium zirconium oxide layer. A top electrode layer formed of TiN having a thickness of 30 nm was deposited by atomic layer deposition on the metal oxide layer. The metal oxide layer contained WO₃. A 400 °C crystallization anneal was applied to the stack for 1 hour, inducing reduction of tungsten cations in the WO₃ and subsequent transfer of oxygen into the hafnium zirconium oxide layer.

A reference ferroelectric device was made wherein the metal oxide layer contained Nb₂O₅, and having otherwise the same properties, and treated with the same crystallization anneal, as the ferroelectric device in accordance with embodiments of the present invention.

Reference is made to FIG. 6, which comprises two plots of the polarization P as a function of applied electric field E. On the left, results for the reference ferroelectric device are shown, while on the right, results for the ferroelectric device in accordance with embodiments of the present invention are shown. The hysteresis loop, typical for ferroelectric materials, may be clearly observed in both plots.

The remanent polarization Pᵣ is the difference between the polarization of the two possible ferroelectric polarization states (i.e., "up" or "down") when no electric field is applied, i.e., at E = 0 MV/cm. It may be observed that the remanent polarization is larger for the ferroelectric device in accordance with embodiments of the present invention, which is attributed to the efficient release of oxygen atoms from the metal oxide layer into the hafnium zirconium oxide layer, and the subsequent conversion of tetragonal phase into orthorhombic phase.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. An intermediate (1, 11) in the formation of a ferroelectric device (10, 110), comprising:
a hafnium zirconium oxide layer (4) comprising a tetragonal phase, and
at least one metal oxide layer (5, 51, 52) in physical contact with the hafnium zirconium oxide layer (4), wherein the metal oxide layer (5, 51, 52) comprises at least one metal cation selected from the list consisting of Cr having an oxidation state of 5 or 6, W having an oxidation state of 5 or 6, Mo having an oxidation state of 5 or 6, Ce having an oxidation state of 4, and V having an oxidation state of 4 or 5, wherein if Cr is present, then W and/or Mo and/or V is also present.

2. The intermediate (1, 11) according to claim 1, wherein the metal oxide layer (5, 51, 52) comprises at least one metal cation selected from the list consisting of Cr having an oxidation state of 6, W having an oxidation state of 6, Mo having an oxidation state of 6, Ce having an oxidation state of 4, and V having an oxidation state of 5.

3. The intermediate (1, 11) according to claim 2, wherein the metal oxide layer (5, 51, 52) is WO₃.

4. The intermediate (1, 11) according to any one of the preceding claims, wherein the metal oxide layer (5, 51, 52) has a thickness of from 0.5 to 5.0 nm, preferably from 1.0 to 2.0 nanometres.

5. A method for forming a ferroelectric device (10, 110), the method comprising the steps:
i) providing the intermediate (1, 11) of any one of claims 1 to 4, then
ii) inducing a reduction of one or more of the at least one metal cation of the metal oxide layer (5, 51, 52) so as to transfer oxygen atoms from the metal oxide layer (5, 51, 52) into the hafnium zirconium oxide layer (4) thereby converting at least part of said tetragonal phase into an orthorhombic phase.

6. The method of claim 5, wherein the hafnium zirconium oxide layer (4) is doped with a redox-active dopant, wherein the dopant and at least one of the at least one metal cation form a redox pair.

7. The method of claim 6, wherein said redox-active dopant is at least one of niobium, chromium, tungsten, cerium, vanadium, and molybdenum, having an oxidation state of at most 4 and cerium having an oxidation state of at most 3.

8. The method of claim 5 to 7, wherein step ii comprises applying a voltage to the intermediate (1, 11) of any one of claims 1 to 4.

9. The method of any one of claims 5 to 8, wherein step ii comprises applying a thermal treatment to the intermediate (1, 11) of any one of claims 1 to 4.

10. The method of any one of claims 5 to 9, wherein the metal oxide layer (5, 51, 52) provided in step i is provided by atomic layer deposition.

11. A ferroelectric device (10, 110) obtainable by the method of any one of claims 5 to 10.

12. The ferroelectric device (10, 110) of claim 9 comprising:
a hafnium zirconium oxide layer (4) comprising an orthorhombic phase, and
at least one metal oxide layer (5, 51, 52) in physical contact with the hafnium zirconium oxide layer (4), wherein the metal oxide layer (5, 51, 52) comprises at least one metal cation selected from the list consisting of Cr, W, V and Mo, having an oxidation state of at most 4, or Ce having an oxidation state of at most 3.

13. The ferroelectric device (10, 110) of claim 11 or claim 12, wherein the ferroelectric device (10, 110) is a ferroelectric capacitor (10), and wherein the hafnium zirconium oxide layer and the at least one metal oxide layer (5, 51, 52) are provided over a bottom electrode layer (2) and below a top electrode layer (6).

14. The ferroelectric device (10, 110) of claim 11 or claim 12, wherein the ferroelectric device (10, 110) is a ferroelectric field-effect transistor (110), and wherein the hafnium zirconium oxide layer and the at least one metal oxide layer (5, 51, 52) are provided over a semiconductor channel (20) and below a top electrode layer (6).

15. A non-volatile memory device (8) comprising a memory cell array, wherein at least one memory cell in the memory cell array comprises a ferroelectric device (10, 110) according to any one of claims 11 to 14.
